# EUROPEAN PATENT APPLICATION

(11) **EP 1 983 649 A1**
(43) Date of publication of application: **22.10.2008**
(21) Application number: 08007616.9
(22) Date of filing: 18.04.2008
(51) Int. Cl.: H03K 19/00

(54) **Standby modes for integrated circuit devices**

(30) Priority: 19.04.2007 GB 0707582
(71) Applicant: Melexis NV, 8900 Ieper (BE)
(72) Inventor: Munder, Gunnar c/o MELEXIS NV, 8900 Ieper (BE)
(74) Representative: Wilson Gunn

(57) **Abstract**

An integrated circuit device comprises an internal pull up current source (Ipup) and a pull up resistor (Rpup) connected in parallel between a voltage supply pin (Vs) and an output node (OUT). A standby switch (SBY) is connected in series with the pull up resistor (Rpup). The standby switch (SBY) is controlled by a standby detect means (SBY Detect), which is also connected to the output node (OUT). If it is desired to switch the device to standby mode, the output node (OUT) is externally drawn to ground by microprocessor (200). The circuit stays in the standby mode as long as the output node (OUT) is drawn to ground. In order to save current during standby mode, the standby detect means (SBY Detect) is operable to disconnect the pull-up resistance (Rpup) by means of standby switch (SBY). As the pull-up resistance (Rpup) is disconnected during the standby mode, the current source (Ipup) supplies a minimal current to the output node (OUT). This ensures that the circuit can always leave an undesired standby mode rapidly.

## Description

The present invention relates to standby modes in integrated circuit devices and in particular to switching such devices between an active mode and a standby mode.

When designing integrated circuit devices, effort is made to reduce the power consumption of the devices and to reduce the size and complexity of the devices and thus reduce the cost.

In order to reduce power consumption when not in use, many modern integrated circuit devices are provided with a standby mode enabling the device to be powered down. Typically, the device might be powered up and down in accordance with a defined duty cycle alternating standby periods with shorter active periods and controlled by signals received from an external source. When powered up from a power down state, the device may need some time to settle into an operating condition during this time, the device is consuming power but not providing any useful functionality. One example of a component that requires this additional settlement time would be an automatic gain control, such as is provided in an IR receiver circuit. The automatic gain control loses its gain state information during power down. Thus, it may need a time of the order of milliseconds to return to an operating state. This delay after power on limits the minimum duration of an active period and hence limits the efficiency of such a method.

A known method of reducing such a power on delay is to switch a resistor into series with the integrated circuit device during a standby (power down) period. The device detects undervoltage on the resistor and turns all active parts into standby. The current through the device is reduced to a minimum. This keeps the automatic gain control alive and thus settling time is not required upon wake up after standby. An alternative solution is described in DE10054529 wherein an external capacitor is provided. The capacitor is used to set the period for stand by and active mode. During stand by, all receiver parts are turned off to reduce power consumption while the Automatic Gain Control remains under power supply and thus keeps its operating state. Unfortunately, both solutions require the provision of additional external components to enable this fast power up which increases the cost and complexity of the device and thus limits the applicability of the solution.

It is therefore an object of the present invention to provide an integrated circuit device adapted to overcome or alleviate at least some of the above problems.

According to the present invention there is provided an integrated circuit device comprising: a standby detect means operable to determine when to switch the device between standby and active modes; a pull up current source; a pull up resistor connected in parallel with said pull up current source; and a stand by switch operable in response to said standby detect means to disconnect said pull up resistor during standby mode.

Preferably, the standby detect means are operable in response to an external control signal. The external control signal may be received at an output node of the device. The external control signal may be a low signal drawing the output node to ground. Preferably, the standby detect means is connected to the output node. Preferably, the standby detect means is operable to detect the output node being drawn to ground. In a preferred embodiment, the device may have a single output node and the external control signal may be received on said single output node.

Preferably, the standby detect means is operable to detect a standby mode control signal when the output node has been drawn to ground for a longer than a predetermined waiting time. A timer means may be provided for measuring the waiting time. The timer means may be integral to the standby detect means. Alternatively, the timer means may be provided elsewhere in the integrated circuit device and connected to the standby detect means.

Preferably, when the device is in standby mode, the pull up resistor is disconnected from the output node in order to reduce current consumption. Preferably, when the device is in standby mode, a minimal current is supplied by the current source, preventing the device being captured in stand by mode if the output node is no longer drawn to ground.

The device may be operable to revert to active mode upon receipt of an external control signal or an internal control signal. The control signal may be a high signal drawing the output node to a high level. The output node may be drawn to a high level by an external supply or by the internal current source. At the time the output node is drawn to a high level, the stand by switch may be operable in response to said standby detect means to connect said pull up resistor.

In order that the invention is more clearly understood, one embodiment is described further below, with reference to the accompanying drawings, in which: -
- Figure 1: is a schematic block diagram of an integrated circuit device of the present invention; and
- Figure 2: is a schematic diagram showing signal levels in the device of figure 1 when switching between active and standby modes.

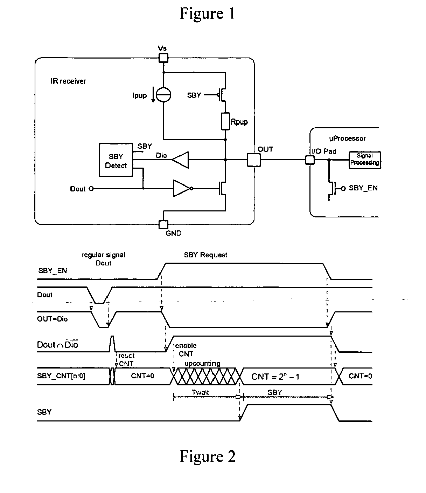

Referring now to figure 1, an integrated circuit device, which may be an IR receiver comprises an internal pull up current source Ipup and a pull up resistor Rpup connected in parallel between a voltage supply pin Vs and an output node OUT. A standby switch SBY is connected in series with the pull up resistor Rpup. The standby switch SBY is controlled by a standby detect means SBY Detect, which is also connected to the output node OUT.

When in active mode, the output node OUT follows the signal Dout, which comes from the operational element of the circuit. In this case Dio is equal to Dout, which is recognised by SBY Detect and thus the device is maintained in active mode.

If it is desired to switch the device to standby mode, the output node OUT is externally drawn to ground by microprocessor 200. The level at OUT is now logically different from the internally set Dout. Thus, SBY Detect recognizes a standby request. An internal timer or counter SBY_CNT is then activated. SBY_CNT waits for a waiting time interval Twait before enabling the standby mode. This enables spikes and transients at the nodes Dout and OUT to be disregarded. Once the waiting time Twait has passed, if OUT and Dout nodes are still logically different, the SBY Detect determines that the device should switch to standby mode.

The circuit stays in the standby mode as long as the OUT is drawn to ground. In order to save current during standby mode, the SBY Detect is operable to disconnect the pull-up resistance Rpup by means of switch SBY. As the pull-up resistance Rpup is disconnected during the standby mode, the current source Ipup supplies a minimal current to OUT. This ensures that the circuit can always leave an undesired standby mode rapidly.

To return the circuit to active mode, the output node OUT is drawn to a high level. OUT can be externally drawn to high level by microprocessor 200 or by internal current source Ipup. However, using the internal current source Ipup may result in a slower transition to active mode. When the SBY Detect determines that the circuit is to be returned to active mode is operable to reconnect the pull-up resistance Rpup by means of switch SBY.

It is of course to be understood that the invention is not to be restricted to the details of the above embodiment which is described by way of example only.

## Claims

1. An integrated circuit device comprising: a standby detect means operable to determine when to switch the device between standby and active modes; a pull up current source; a pull up resistor connected in parallel with said pull up current source; and a stand by switch operable in response to said standby detect means to disconnect said pull up resistor during standby mode.

2. An integrated circuit device as claimed in claim 1 wherein the standby detect means are operable in response to an external control signal.

3. An integrated circuit device as claimed in claim 2 wherein the external control signal is received at an output node of the device.

4. An integrated circuit device as claimed in claim 3 wherein the external control signal is a low signal drawing the output node to ground.

5. An integrated circuit device as claimed in claim 4 wherein the standby detect means is connected to the output node and is operable to detect the output node being drawn to ground.

6. An integrated circuit device as claimed in claim 5 wherein the device has a single output node and the external control signal is received on said single output node.

7. An integrated circuit device as claimed in claim 6 wherein the standby detect means is operable to detect a standby mode control signal when the output node has been drawn to ground for a longer than a predetermined waiting time.

8. An integrated circuit device as claimed in claim 7 wherein a timer means is provided for measuring the waiting time.

9. An integrated circuit device as claimed in any preceding claim wherein when the device is in standby mode, the pull up resistor is disconnected from the output node in order to reduce current consumption.

10. An integrated circuit device as claimed in any preceding claim wherein when the device is in standby mode, a minimal current is supplied by the current source, preventing the device being captured in stand by mode if the output is no longer drawn to ground.

11. An integrated circuit device as claimed in any preceding claim wherein the device is operable to revert to active mode upon receipt of an external control signal or an internal control signal.

12. An integrated circuit device as claimed in claim 11 wherein the control signal is a high signal drawing the output node to a high level.

13. An integrated circuit device as claimed in claim 12 wherein the output node is drawn to a high level by an external supply or by the internal current source.

14. An integrated circuit device as claimed in claim 13 wherein at the time the output node is drawn to a high level, the stand by switch is operable in response to said standby detect means to connect said pull up resistor.
